(19) **Europäisches Patentamt / European Patent Office / Office européen des brevets**

(11) **EP 4 453 588 B1**

(12) **FASCICULE DE BREVET EUROPEEN**

(45) Date de publication et mention de la délivrance du brevet:
**27.08.2025 Bulletin 2025/35**

(21) Numéro de dépôt: **22821561.2**

(22) Date de dépôt: **12.12.2022**

(51) Classification Internationale des Brevets (IPC):
**G01R 31/3842** (2019.01)   **G01R 31/396** (2019.01)
**H02J 7/00** (2006.01)

(52) Classification Coopérative des Brevets (CPC):
**G01R 31/396; G01R 31/3842; H02J 7/00714; H02J 7/007182; H02J 7/007194;** Y02E 60/10

(86) Numéro de dépôt international:
**PCT/EP2022/085463**

(87) Numéro de publication internationale:
**WO 2023/117556 (29.06.2023 Gazette 2023/26)**

(54) **PROCÉDÉ ET SYSTÈME DE GESTION D'UN DISPOSITIF DE BATTERIE D'UN VÉHICULE ÉLECTRIQUE OU HYBRIDE CONTENANT UNE MESURE DE TENSION DES CELLULES RELIÉES À UNE BARRE D'INTERCONNEXION**

VERFAHREN UND SYSTEM ZUR VERWALTUNG EINER BATTERIEVORRICHTUNG EINES ELEKTRO- ODER HYBRIDFAHRZEUGS MIT EINER SPANNUNGSMESSUNG DER MIT EINER VERBINDUNGSSTANGE VERBUNDENEN ZELLEN

METHOD AND SYSTEM FOR MANAGING A BATTERY DEVICE OF AN ELECTRIC OR HYBRID VEHICLE CONTAINING A VOLTAGE MEASUREMENT OF THE CELLS CONNECTED TO AN INTERCONNECTION BAR

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **23.12.2021 FR 2114312**

(43) Date de publication de la demande:
**30.10.2024 Bulletin 2024/44**

(73) Titulaires:
• **Ampere SAS**
  **92100 Boulogne-Billancourt (FR)**
• **Nissan Motor Co., Ltd.**
  **Yokohama, Kanagawa 221-0023 (JP)**

(72) Inventeurs:
• **GUISSI, Laila**
  **78084 Guyancourt Cedex (FR)**
• **HADJ-HAMOU, Rayan**
  **78084 Guyancourt Cedex (FR)**
• **KALAWOUN, Jana**
  **78084 Guyancourt Cedex (FR)**
• **VAFLARD, Nicolas**
  **78084 Guyancourt Cedex (FR)**

(74) Mandataire: **Novaimo**
**Europa 1**
**362, avenue Marie Curie**
**Archamps Technopole**
**74166 Saint-Julien-en-Genevois Cedex (FR)**

(56) Documents cités:
**FR-A1- 3 002 325    US-B2- 9 733 311**

**Description**

L'invention concerne un procédé et un système de gestion d'un dispositif de batterie électrique. L'invention porte encore sur un véhicule automobile à motorisation électrique ou hybride équipé dudit système et/ou mettant en œuvre le procédé mentionné.

Les véhicules à motorisation hybride ou électrique sont équipés d'un dispositif de batterie, aussi appelé simplement « batterie », pour le stockage d'énergie électrique, apte à alimenter en énergie électrique au moins un élément d'une chaîne d'entraînement électrique du véhicule. Ces dispositifs de batterie comprennent classiquement une pluralité de modules reliés les uns aux autres par des barres d'interconnexion, ou « busbar » en anglais, afin d'assurer la continuité électrique du dispositif. Chacun de ces modules comporte une pluralité de cellules électrochimiques, celles-ci pouvant alors être reliées ou non à l'une des barres d'interconnexion du dispositif.

En utilisation, les dispositifs de batteries sont contrôlés et surveillés par un système de gestion dédié, dit « Battery Management System » ou « BMS » de manière à surveiller et contrôler l'état et le fonctionnement des différentes cellules du dispositif de batterie en fonction de différents modes d'utilisation tels que, par exemple, la charge branchée à un réseau de distribution, la décharge en roulage ou la charge régénérative au freinage. Un tel système permet également, directement ou indirectement, l'estimation de paramètres relatifs au dispositif de batterie tels que l'état de charge, ou « SOC » pour « State of Charge », l'état de santé, ou «SOH » pour « State of Health », et/ou tout autre paramètre relatif à des procédés et fonctions de protection de la batterie, par exemple des procédés sécuritaires visant à maintenir le dispositif dans des plages de valeurs de tensions et/ou de températures prédéfinies afin d'en assurer la durabilité.

Les systèmes de gestion de batterie existants présentent une structure maître-esclave qui comprend d'une part une unité maître de traitement, distante du dispositif de batterie, qui a notamment fonction d'unité de contrôle et/ou de calculateur, et, d'autre part, une pluralité d'éléments « esclaves », comprenant des capteurs de tension et de température, disposés au niveau du dispositif de batterie afin de collecter des données qui sont ensuite transmises à l'unité maître de traitement.

Dans les dispositifs de batterie actuels, chacun des différents modules est équipé d'au moins un élément esclave. Lorsque le nombre de cellule d'un module est inférieur au nombre de voies de mesures d'un élément esclave considéré, la capacité de collecte dudit élément n'est pas pleinement exploitée, ce qui entraîne d'une part une sous-exploitation des différents éléments esclaves et, d'autre part une augmentation des coûts et de la masse du dispositif de batterie du fait du nombre important d'éléments esclaves nécessaires pour équiper l'ensemble des modules du dispositif.

Afin de résoudre un tel problème, il est connu, par exemple tel qu'exposé dans la demande chinoise CN107482699, de mettre en œuvre une architecture du dispositif de batterie dans laquelle un même élément esclave est utilisé pour collecter des données au niveau de deux modules distincts, une partie des voies de mesures étant dédiée à un premier module tandis que les voies restantes sont dédiées à un second module. Une telle architecture permet avantageusement d'utiliser les différents éléments esclaves à leur pleine capacité et ainsi d'en réduire le nombre. Les systèmes de gestion connus sont néanmoins inadaptés à une telle architecture. En effet, les mesures de tensions réalisées par les éléments esclaves sur les cellules portant une barre d'interconnexion sont biaisées par la présence de celle-ci. La tension mesurée comprend une tension additionnelle propre à la barre d'interconnexion qui, selon le mode d'utilisation du dispositif de batterie, entraîne la surestimation ou la sous-estimation des tensions. Il en résulte que l'estimation des paramètres précités, tels que le SOH ou SOC, sont basés sur des valeurs de tensions qui peuvent être erronées et que tout procédé sécuritaire de fonctionnement du dispositif de batterie utilisant ces valeurs de tension peut être déclenché de manière inadaptée.

La demande de brevet française FR3002325 et le brevet américain US9733311 divulguent des exemples de procédés et systèmes de gestion d'un dispositif de batterie d'un véhicule électrique ou hybride.

L'invention s'inscrit dans ce contexte et vise à fournir un procédé et un système de gestion du dispositif de batterie remédiant aux inconvénients susnommés. En particulier, l'invention vise à assurer une estimation affinée des valeurs de tension des différentes cellules afin d'optimiser les conditions de fonctionnement et la durabilité du dispositif de batterie.

L'invention concerne un procédé de gestion d'un dispositif de batterie électrique comprenant une pluralité de modules montés en série comportant chacun une pluralité de cellules montées en série, chaque module étant directement électriquement relié à au moins un autre module de la pluralité de modules de manière à former une paire de modules, cette liaison étant réalisée par l'intermédiaire d'une barre d'interconnexion reliée au niveau d'une cellule de chacun des modules de la paire. Le procédé de gestion comprend :

- une étape de mesure d'une tension propre à chaque cellule, liée ou non à une barre d'interconnexion, par l'intermédiaire d'éléments esclaves et une étape de mesure de la température de chaque module, chaque mesure de température étant associée à la ou aux barre(s) d'interconnexion reliée(s) au module considéré, chaque élément esclave comprenant une pluralité de voies de mesures et étant relié aux deux modules de la paire considérée;
- une étape de mesure d'un courant circulant dans le dispositif de batterie
- une étape de transmission des mesures à une unité de traitement distante du dispositif de batterie ;

- une étape d'estimation d'une valeur de compensation de tension propre à chaque cellule reliée à une barre d'interconnexion, la valeur de compensation correspondant à une tension estimée de la barre d'interconnexion considérée pour chacune desdites cellules, la valeur de compensation étant estimée en fonction de la température et du courant du module comprenant la cellule considérée ;
- une étape d'estimation d'une valeur de tension corrigée propre à chacune des cellules reliées à une barre d'interconnexion par compensation de la valeur de tension mesurée avec la valeur de compensation estimée ;
- une étape d'ajustement et/ou de détermination d'au moins un paramètre limitatif et/ou d'état du fonctionnement du dispositif de batterie en fonction de la tension corrigée estimée et/ou en fonction de la tension mesurée.

Notamment, la valeur de compensation peut dépendre d'une résistance estimée de la barre d'interconnexion reliée à la cellule considérée.

Notamment, l'étape de détermination d'au moins un paramètre limitatif et/ou d'au moins un paramètre d'état peut comprendre :

- une sous-étape de détermination d'une valeur maximale de tension propre à une cellule parmi un ensemble formé des valeurs de tension mesurées, pour les cellules n'étant pas reliées à une barre d'interconnexion, et des tensions corrigées estimées, pour les cellules reliées à au moins une barre d'interconnexion ; et
- une sous-étape de détermination, en fonction de la valeur maximale de tension, d'une puissance de charge pouvant être allouée au dispositif de batterie lorsque celui-ci est dans un mode de charge, la puissance de charge étant limitée lorsque la valeur maximale de tension est supérieure ou égale à un seuil maximal de tension de charge ; et/ou
- une sous-étape de détermination, en fonction de la valeur maximale de tension, d'une puissance de charge régénérative pouvant être allouée au dispositif de batterie lorsque celui-ci est dans un état de charge régénérative, la puissance de charge régénérative étant limitée lorsque la valeur maximale de tension est supérieure ou égale à un seuil maximal de tension de charge régénérative.

Le procédé peut, en outre, comprendre une étape de détermination d'un mode d'utilisation du dispositif de batterie électrique parmi un mode de charge, de décharge ou de charge régénérative, le procédé exécutant, lorsqu'un un mode de charge, est détecté, une étape de régulation de la puissance de charge comportant :

- une sous-étape de calcul d'une variation de la puissance de charge entre les puissances de charge observées respectivement entre deux instants $t_{n-1}$ et $t_n$;
- une sous-étape d'estimation d'une puissance de charge à mettre en œuvre à un instant $t_{n+1}$ à venir, et une sous-étape de détection d'une augmentation à venir de la puissance de charge relativement à la variation de puissance précédemment calculée et à la puissance de charge observée à l'instant $t_n$;
- une étape de limitation de la puissance de charge à venir de sorte que, à l'instant $t_{n+1}$ la puissance de charge est limitée de manière à être inférieure ou égale à la puissance de charge mise en œuvre à l'instant $t_n$, la limitation de la puissance de charge étant levée lorsqu'il est détecté une variation de température d'au moins un module supérieure à un seuil de température prédéterminé entre les instants $t_{n-1}$ et $t_n$.

L'étape de détermination d'au moins un paramètre limitatif et/ou d'au moins un paramètre d'état peut comprendre :

- une sous-étape de détermination d'une valeur minimale de tension d'une cellule parmi un ensemble comprenant les valeurs de tension mesurées, pour les cellules n'étant pas reliées à une barre d'interconnexion, et parmi les tensions corrigées estimées, pour les cellules reliées à une barre d'interconnexion ;
- une sous-étape de détermination d'une puissance de décharge du dispositif de batterie en fonction de la valeur minimale de tension, la puissance de décharge étant limitée lorsque la valeur minimale de tension est inférieure ou égale à un seuil minimal de tension de décharge.

L'étape de détermination d'au moins un paramètre limitatif et/ou d'au moins un paramètre peut comprendre :

- une sous-étape d'estimation d'une résistance de chaque cellule reliée à une barre d'interconnexion à un instant $t_x$, comprenant le calcul d'une résistance moyenne des cellules du dispositif de batterie n'étant pas reliées à une barre d'interconnexion en fonction des tensions mesurées pour ces cellules et l'attribution de la valeur d'une telle moyenne à chaque cellule reliée à une barre d'interconnexion ;
- une sous-étape de détermination d'une puissance de décharge pouvant être allouée au dispositif de batterie lorsque la valeur minimale de tension est supérieure au seuil minimal de tension de décharge, la puissance de décharge étant déterminée en fonction des résistances des différentes cellules et de la température mesurée pour chaque module .

L'étape de détermination d'au moins un paramètre limitatif et/ou d'au moins un paramètre peut comprendre une sous-étape d'estimation d'un état de charge des différentes cellules du dispositif de batterie :

- l'état de charge des cellules n'étant pas reliées à une barre d'interconnexion étant défini en fonction de la tension mesurée et du courant qui leur sont propres ;
- l'état de charge des cellules reliées à une barre d'interconnexion étant défini en fonction du courant qui lui est propre .

L'invention concerne également un système de gestion d'un dispositif de batterie électrique comprenant une pluralité de modules comportant chacun une pluralité de cellules, chaque module étant directement électriquement relié à au moins un autre module de la pluralité de modules de manière à former une paire de modules, cette liaison étant réalisée par l'intermédiaire d'une barre d'interconnexion liée au niveau d'une cellule de chacun des modules de la paire, les différents modules étant électriquement relié les uns aux autres, le système comprenant des éléments matériels et/ou logiciels mettant en œuvre le procédé de gestion selon l'invention, les éléments matériels comportant au moins un élément esclave apte à réaliser des mesures de températures et de tension relié à chacun des modules de la paire, une unité de traitement apte à recevoir des mesures de l'au moins un élément esclave, une unité de mémoire et au moins un capteur de courant.

L'invention s'étend également à un véhicule automobile à motorisation hybride ou électrique comprenant au moins un dispositif de batterie électrique comprenant une pluralité de modules comportant chacun une pluralité de cellules, chaque module étant électriquement relié à chacun des autres modules de la pluralité de modules par l'intermédiaire d'une barre d'interconnexion au niveau d'au moins une cellule, le véhicule étant, en outre, équipé d'un système de gestion selon la revendication précédente.

D'autres détails, caractéristiques et avantages ressortiront plus clairement à la lecture de la description détaillée donnée ci-après, à titre indicatif et non limitatif, en relation avec les différents exemples de réalisation illustrés sur les figures suivantes :

La figure 1 représente schématiquement un mode de réalisation d'un véhicule équipé d'un système de gestion d'un dispositif de batterie.

La figure 2 est un ordinogramme d'un exemple d'exécution d'un procédé de gestion du dispositif de batterie.

La figure 3 est un ordinogramme d'un exemple d'exécution particulier du procédé du dispositif de batterie illustré à la figure 2.

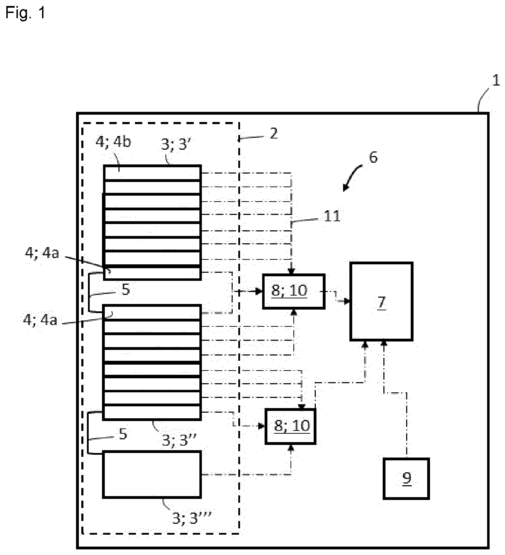

La figure 1 illustre schématiquement un véhicule 1 automobile à motorisation électrique ou hybride. Le véhicule 1 peut être de toute nature, c'est-à-dire qu'il peut s'agir d'un véhicule particulier, d'un véhicule utilitaire, d'un camion ou d'un bus. Également, le véhicule 1 peut être un véhicule autonome ou non autonome.

Le véhicule 1 est équipé d'un dispositif de batterie 2 électrique, aussi qualifié de « batterie », « dispositif de stockage d'énergie électrique » ou encore « battery pack » en anglais, configuré pour alimenter un ou plusieurs élément(s) d'une chaîne d'entraînement électrique du véhicule 1, non représentée, en énergie électrique. Par exemple, il peut alimenter un moteur électrique.

Le dispositif de batterie 2 comprend une pluralité de modules 3 électriquement montés en série. Chaque module 3 comporte une pluralité de cellules 4 électrochimiques montées en série au sein d'un même module. Les différents modules 3 sont électriquement reliés les uns aux autres par l'intermédiaire de barres d'interconnexion 5, aussi connues sous le nom de « busbar », pouvant par exemple être réalisée en cuivre. Chaque module est directement relié électriquement à au moins un autre module de la pluralité de modules 3, notamment un module adjacent au sein du dispositif de batterie 2, de manière à former une paire de modules 3. On entend par « directement reliés » que ces modules 3 sont liés l'un à l'autre par une unique barre d'interconnexion 5, sans qu'une autre barre d'interconnexion ou un autre module soit électriquement interposé entre eux.

Ainsi, un dispositif de batterie 2 comprenant un nombre k de modules 3 peut, de manière non limitative, comprendre un nombre k-1 de barres d'interconnexion 5 permettant de relier des modules 3 successifs, ou adjacents, les uns aux autres. Chaque module du dispositif comprend ainsi au moins une cellule 4a reliée à une barre d'interconnexion 5, et au moins une cellule 4b n'étant pas reliée à une telle barre. A des fins de clarté dans l'exemple illustré, seuls deux modules 3 distincts formant une paire et comprenant chacun huit cellules 4 sont représentés. Il est entendu qu'une telle représentation n'est en rien limitative et que le dispositif pourra comprendre davantage de modules 3 et/ou un nombre différent de cellules 4.

Le véhicule 1 est, en outre, équipé d'un système de gestion 6 du dispositif de batterie 2. Le système de gestion 6 comprend des éléments matériels et/ou logiciels mettant en œuvre un procédé de gestion 100 tel qu'exposé ci-après. Les éléments matériels comportent une unité de traitement 7 et un ou plusieurs élément(s) esclave(s) 8, ou « slave » en anglais, comprenant une pluralité de voies de mesures de température et de tension. Le système peut en outre comprendre une unité de mémoire 9 et au moins un capteur 10 de courant circulant dans le dispositif de batterie 2.

Le système de gestion 6 est organisé selon une architecture dite « maître-esclave » dans laquelle l'unité de traitement 7, aussi qualifiée d'unité maître de traitement 7, est distante du dispositif de batterie 2 et est configurée pour recevoir les données des différents éléments « esclaves » 8, comprenant en particulier des capteurs de tension et température, afin d'en effectuer le traitement.

L'unité de traitement 7 comprend au moins un calculateur comportant des ressources matérielles et logicielles plus précisément au moins un processeur, ou microprocesseur. L'unité de traitement 7 coopère avec l'unité de mémoire 9, les éléments esclaves 8 et le capteur 10 et a fonction de « maître » dans l'architecture du système de gestion 6. L'unité de traitement 7 est apte à exécuter des instructions pour la mise en œuvre d'un programme d'ordinateur.

Le système de gestion 6 comprend une pluralité de capteurs 8 de tension et de température agencés au niveau des modules 3 du dispositif de batterie 2. De tels capteurs ont fonction d'éléments « esclaves » au sein du système. Chaque élément esclave 8 comprend une pluralité de voies de mesure 11. Particulièrement, chaque élément(s) esclave 8 comprend un nombre de voies supérieur au nombre de cellules 4 comprises dans chaque module 3 du dispositif de batterie 2. Au sein du système selon l'invention, chaque élément esclave 8 est configuré de manière à pouvoir réaliser des mesures sur deux modules 3 distincts de la pluralité de modules 3, notamment sur les modules 3 d'une paire considérée telle qu'exposée plus haut. En l'espèce, un premier élément esclave 8, comprenant au moins un capteur de tension et température, comprend douze voies, huit étant consacrées aux huit cellules 4 d'un premier module 3' de la paire tandis que les quatre restantes sont reliées à quatre cellules 4 d'un deuxième module 3" de la paire, distinct du premier module 3'. Un deuxième élément esclave 8 similaire, partiellement représenté, est relié aux quatre cellules 4 restantes du deuxième module 3" tandis que les huit autres voies sont reliées à un troisième module 3'''. Également, il est entendu que ledit deuxième module 3" est relié, par l'intermédiaire d'une barre d'interconnexion 5, audit troisième module, le deuxième module et le troisième module formant ainsi une paire reliée par une barre d'interconnexion 5 qui leur est propre. Selon un exemple de réalisation non limitatif, une dernière cellule 4 du premier module 3' est reliée à une barre d'interconnexion elle-même reliée à une première cellule 4 du deuxième module 3". On entend ici par « première » et « dernière » la première cellule et la dernière cellule au sein du montage électrique en série du module considéré. De la même façon, une dernière cellule 4 du deuxième module 3" est reliée à une première cellule 4 du troisième module 3'''. Un tel principe est reproduit *mutatis mutandis* pour l'ensemble des modules 3 du dispositif de batterie 2.

Du fait de la continuité de mesure, il est connu que, lorsqu'un élément esclave est utilisé pour gérer deux modules 3 de batterie distincts, la mesure de tension effectuée au niveau d'une cellule reliée à au moins une barre d'interconnexion 5 comprend une tension additionnelle correspondant à la tension propre à ladite barre d'interconnexion 5. C'est notamment le cas de la « dernière cellule » 4 telle qu'exposée plus haut. Il en résulte une mesure erronée de la tension des cellules 4a reliées à une barre d'interconnexion. En effet, la barre d'interconnexion 5 présente une résistance plus élevée ce qui entraîne une différence de tension entre les deux cellules 4a de batterie connectées aux deux extrémités de ladite barre. La tension additionnelle de la barre d'interconnexion 5, tel que davantage exposé si après, dépend de sa résistance, laquelle peut être amenée à varier selon :

- la taille et la composition de la barre d'interconnexion 5,
- la qualité de contact et de serrage entre le module et la barre d'interconnexion,
- la température de la barre d'interconnexion 5, et
- l'état de vieillissement de la surface de la barre d'interconnexion 5.

L'importance de la tension additionnelle due à la barre d'interconnexion 5, autrement dit la différence entre la tension mesurée et la tension réelle d'une cellule 4a reliée à ladite barre, affecte le fonctionnement du dispositif de batterie 2 dans ses différents modes d'utilisation ou de fonctionnement. Par exemple, lors de la charge du dispositif de batterie 2, une telle tension additionnelle induit une surestimation de la tension mesurée relativement aux cellules 4 n'étant pas reliées à au moins une barre d'interconnexion 5. Inversement, lors de la décharge du dispositif, une sous-estimation de cette tension est observée. En particulier, dans les cas de la charge, plus les courants mis en œuvre sont importants, par exemple dans le cas des charges rapides (« Fast charge » ou « Ultra fast charge ») et plus la tension additionnelle est importante.

Ces mesures erronées de la tension des cellules 4a reliées à au moins une barre d'interconnexion 5 affectent également différents paramètres relatifs au dispositif de batterie 2, tels que la puissance, son état de charge ou son état de santé comme exposé précédemment et influencent le fonctionnement de divers systèmes régulant l'utilisation du dispositif de batterie 2 sur la base de tels paramètres, davantage exposés en référence au procédé ci-après, ce qui impacte l'exploitation de la performance du dispositif de batterie 2.

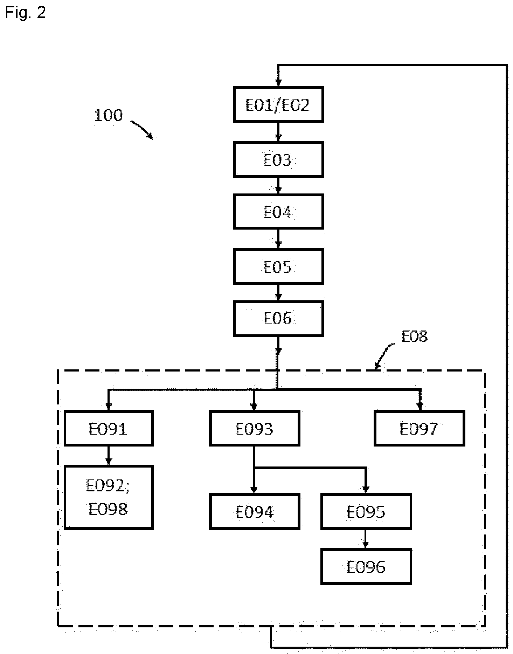

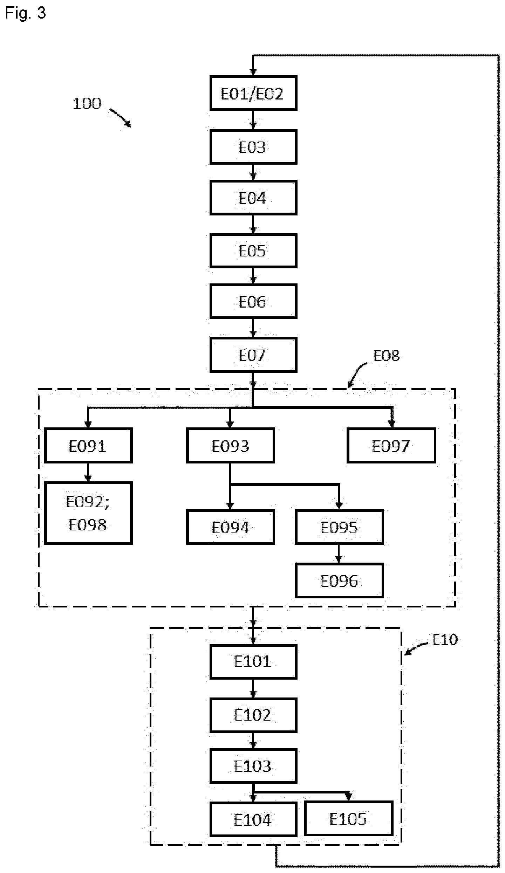

En ce sens, un mode d'exécution d'un procédé de gestion 100 permettant une estimation plus exacte de ces tensions ainsi que de différents paramètres relatifs au dispositif de batterie 2, est décrit ci-après en référence aux figures 2 et 3.

De manière générale, le procédé de gestion 100 comprend, dans un premier temps, une étape de mesure E01 d'une tension $V_{m\_cell}$ propre à chaque cellule du dispositif de batterie 2. Ces mesures sont réalisées par l'intermédiaire des éléments esclaves 8. Comme exposé plus haut, chaque élément esclave 8 comprend une pluralité de voies 11 de mesures et est relié à au moins deux modules 3 distincts. Le nombre de voie de mesures d'un capteur considéré est notamment supérieur au nombre de cellules 4 propres aux modules 3 auxquels il est relié.

Le procédé comprend également une étape de mesure E02 de la température $T_{mod}$ de chaque module 3 du dispositif de batterie 2. Chaque mesure de température $T_{mod}$ d'un module 3 est ensuite associée à la ou les barre(s) d'interconnexion 5 reliée(s) au module 3 considéré afin de permettre, tel que davantage exposé ci-après, une estimation de la température de la barre d'interconnexion 5 sur la base de l'échauffement du module. Notamment, pour chaque barre d'interconnexion 5 considérée la température $T_{mod}$ mesurée associée est celle propre au module de la paire de modules 3 qu'elle relie comprenant la cellule dont la tension est erronée du fait de la présence de ladite barre d'interconnexion 5. En l'espèce, dans l'exemple précédemment exposé, chaque barre d'interconnexion 5 se voit associer la température $T_{mod}$ mesurée propre au module 3 de la paire comprenant la dernière cellule 4 dans le montage électrique en série. Pour les modules illustrés, dans la paire formée par le premier module 3' et le deuxième module 3", la barre d'interconnexion 5 se voit associer la température du premier module 3'.

Les mesures de tension $V_{m\_cell}$ et de température $T_{mod}$ peuvent être réalisées en temps réel, c'est-à-dire en continu, ou, de manière alternative, à intervalle de temps régulier préprogrammé. Les mesures de température et de tension peuvent être réalisées simultanément ou successivement l'une à l'autre.

Le système de gestion 6 exécute également une étape de mesure E03 d'un courant $I_m$ circulant dans le dispositif de batterie 2 par l'intermédiaire du ou des capteur(s) de courant 10. Le courant est évalué à l'échelle du dispositif de batterie 2.

Similairement aux mesures de tension $V_{m\_cell}$ et de température $T_{mod}$, le courant $I_m$ peut être mesuré en temps réel, ou, de manière alternative, à intervalle de temps régulier préprogrammé. Le courant peut également être mesuré simultanément ou successivement aux mesures de température et/ou de tension.

Le système comprend ensuite une étape de transmission E04 des mesures de tension $V_{m\_cell}$ et de température $T_{mod}$ réalisées par les éléments esclaves 8 à l'unité de traitement 7, distante. Il en va de même pour les mesures de courant $I_m$.

L'unité de traitement 7 exécute ensuite une étape d'estimation E05 d'une valeur de compensation $V_{b\_est}$ de tension propre à chaque cellule 4a reliée à une barre d'interconnexion 5. Une telle valeur de compensation $V_{b\_est}$ correspond à une tension estimée propre à une barre d'interconnexion 5 considérée pour chacune desdites cellules 4a. La valeur de compensation est estimée par l'intermédiaire du courant $I_m$ et d'une estimation de la résistance $R_{est}$ de la barre d'interconnexion 5 reliée à la cellule 4a, obtenue en fonction notamment de la température mesurée $T_{mod}$ du module 3 comprenant la cellule considérée, la température de la barre d'interconnexion 5 ne pouvant être directement mesurée. La valeur de compensation $V_{b\_est}$ de tension propre à chaque cellule 4a reliée à une barre d'interconnexion 5 correspond ici au produit du courant $I_m$ et de l'estimation de la résistance $R_{est}$ de la barre d'interconnexion liée à la cellule 4a considérée.

Il est ainsi avantageusement possible de prendre en considération une variation dans le comportement des cellules 4 d'un même module 3, notamment une variation du comportement de la ou les cellule(s) 4a reliée(s) à une ou des barre(s) d'interconnexion 5 relativement à des cellules 4b non reliées à une barre d'interconnexion 5.

La résistance estimée $R_{est}$ peut particulièrement être définie selon :

$$(1)\ R_{est} = R_{ref} \times \left( 1 + \alpha_1 \times \left( T_{mod} - T_{ref} \right) \right)$$

$$+ R_{cont} \times \left( 1 + \alpha_2 \times \left( T_{mod} - T_{ref} \right) \right)$$

Où :

$R_{est}$ est la valeur estimée de la résistance de la barre d'interconnexion 5. $T_{ref}$ est une valeur de température fixe, de référence. En l'espèce, de manière non limitative, cette température est de 20°C. $R_{ref}$ est une valeur fixe d'estimation de la résistance de la barre d'interconnexion 5 à la température de référence $T_{ref}$. Cette valeur peut être définie ou calibrée au préalable et enregistrée sur l'unité de mémoire 9. Elle est déterminée selon les dimensions de la barre d'interconnexion 5, la résistance de celle-ci augmentant avec sa taille, et selon sa composition. $T_{mod}$ est la température mesurée du module auquel la barre d'interconnexion 5 considérée est liée. La différence réalisée entre la température mesurée $T_{mod}$ et la température de référence $T_{ref}$ est ainsi représentative d'un échauffement, par exemple du fait de son usage ou de sa charge, du dispositif de batterie 2. $R_{cont}$ est une valeur fixe estimée de la résistance de contact existant entre le module considéré et la barre d'interconnexion 5 qui lui est reliée. Cette valeur peut être définie ou calibrée au préalable et enregistrée sur l'unité de mémoire 9. La résistance de contact $R_{cont}$ est définie en fonction de la qualité de contact et du serrage entre la barre d'interconnexion 5 et le module considéré. $\alpha_1$ est une valeur fixe représentative de l'augmentation de la résistance de référence $R_{ref}$ en fonction de la température. Particulièrement, $\alpha_1$ est le coefficient directeur d'une droite représentative de l'évolution de la résistance de référence en fonction de la température, calibrée au préalable. $\alpha_2$ est une valeur fixe représentative de l'augmentation de la résistance de contact $R_{cont}$ en fonction de la température. Similairement à $\alpha_1$, il s'agit du coefficient directeur d'une droite représentative de l'évolution de la résistance de contact en fonction de la température, calibrée au préalable. Les valeurs $\alpha_1$ et $\alpha_2$ sont définies avant l'exécution du procédé, notamment préalablement à l'assemblage du véhicule, et sont enregistrées sur l'unité de mémoire 9 de manière à être accessibles à l'unité de traitement 7.

Comme exposé précédemment, la résistance $R_{est}$ de la barre d'interconnexion 5 varie selon des paramètres tels que sa taille, sa composition, la qualité de contact et de serrage entre le module et la barre d'interconnexion, la température de la barre d'interconnexion 5 ou encore l'état de vieillissement de la surface de la barre d'interconnexion 5. L'équation exposée ci-dessus permet une estimation de la résistance propre à la barre d'interconnexion 5 considérée, et par voie de conséquence l'estimation de la tension additionnelle résultante par simple multiplication avec la valeur de courant mesurée. L'estimation réalisée prend ainsi en considération ces paramètres afin de réaliser une estimation basse de la valeur de tension de manière à corriger, intégralement ou en partie, l'excès positif en cas de courant chargeant ou négatif en cas de courant déchargeant de tension mesuré dû à la barre d'interconnexion 5 considérée. En effet, il est essentiel de ne pas surestimer la valeur de compensation au risque de générer des situations de surtension ou de sous-tension, davantage exposées ci-après, susceptibles d'affecter la durabilité des différentes cellules 4.

Le système de gestion 6 peut ainsi obtenir une estimation E06 d'une valeur de tension corrigée $V_{corr}$ propre à chacune des cellules 4 reliées à une barre d'interconnexion 5. La tension corrigée estimée correspond à la tension mesurée de la cellule corrigée de manière à faire abstraction de la tension additionnelle propre à la barre d'interconnexion 5. Une telle tension est avantageusement plus représentative de la situation réelle, c'est-à-dire de la tension réelle, de la cellule 4 considérée que la tension mesurée $V_{m\_cell}$. La tension corrigée $V_{corr}$ estimée de la cellule est définie comme suit :

$$(2) \quad V_{corr} = V_{m\_cell} - R_{est} \times I_m = V_{cell} - V_{b\_est}$$

Où :

$R_{est}$ est la valeur estimée de la résistance de la barre d'interconnexion 5 précédemment calculée pour les cellules 4a reliées à une barre d'interconnexion 5. A noter que la valeur $R_{est}$ est nulle pour les cellules 4b n'étant pas reliées à une barre d'interconnexion 5. $V_{m\_cell}$ est la tension de la cellule préalablement mesurée et $I_m$ est le courant mesuré.

De manière optionnelle, visible à la figure 3, le système peut exécuter, en parallèle ou suite aux étapes précédemment exposées, une étape de détermination E07 d'un mode d'utilisation du dispositif de batterie 2 électrique parmi un mode de charge, de décharge ou de charge régénérative. On entend par exemple par « décharge » que le véhicule 1 est dans une phase de roulage. On entend par « charge régénérative » la récupération d'énergie électrique résultant du freinage du véhicule 1. Par exemple, l'unité de traitement 7 reçoit un signal renseignant le mode d'utilisation du dispositif de batterie 2 à un instant *t* auquel le procédé selon l'invention est mis en œuvre.

Le système de gestion 6 met ensuite en œuvre une étape d'ajustement et/ou de détermination E08 d'au moins un paramètre limitatif du fonctionnement du dispositif de batterie 2 et/ou d'au moins un paramètre d'évaluation d'un état dudit dispositif de batterie en fonction de la tension corrigée $V_{corr}$ déterminée et/ou en fonction de la tension mesurée $V_{m\_cell}$. Notamment, un tel paramètre peut être directement ou indirectement lié à l'un des modes d'utilisation du dispositif de batterie 2. Une telle étape peut, de manière particulière, correspondre à l'ajustement ou à l'actualisation d'une valeur existante du paramètre considéré, par exemple résultant d'un cycle antérieur d'exécution du procédé selon l'invention et préalablement enregistrée sur l'unité de mémoire 9 ou tout autre élément de mémoire du véhicule 1.

Les figures 2 et 3 illustrent la détermination E08 de paramètres relatifs aux modes « charge » ou « charge régénérative ». Le mode « charge » peut aussi bien concerner une situation de charge normale qu'une charge rapide (« Fast charge ») ou ultra rapide (« Ultra Fast Charge »).

Classiquement, lors des phases de charge ou de charge régénérative, des procédés sécuritaires permettent de limiter, c'est-à-dire réduire, une puissance de charge allouée relativement à la capacité maximale. Ces procédés sécuritaires, aussi connus sous le terme anglais « derating », sont mis en œuvre afin de maintenir la température et/ou la tension des différentes cellules 4 dans des plages de valeurs adaptées prédéterminées. De tels procédés visent à éviter des situations de surtension ou de surchauffe, notamment afin d'assurer la durabilité du dispositif de batterie 2. Ces procédés permettent donc d'adapter une puissance de charge $P_c$, ou une puissance de charge régénérative $P_{c\_regen}$, en fonction de la tension mesurée $V_{m\_cell}$ des cellules 4, ladite puissance étant limitée dès lors que la tension d'une cellule est supérieure ou égale à un seuil de tension maximale prédéterminé, propre à l'état de charge considéré.

La puissance de charge $P_c$, ou de charge régénérative $P_{c\_regen}$, peut ainsi être définie en se basant sur une cartographie 2D en fonction de la température $T_{mod}$ et de la tension mesurée $V_{m\_cell}$ en conditions normales, c'est-à-dire quand les températures et tensions mesurées sont comprises dans les plages de valeur acceptées, et, lorsque la tension mesurée $V_{m\_cell}$ est supérieure au seuil de tension maximale, la puissance est réduite. Dans le cas d'une architecture de dispositif de batterie 2 telle qu'exposé plus haut, les mesures de tension $V_{m\_cell}$ des cellules 4 reliées à une barre d'interconnexion 5 sont erronées. En particulier, dans le cas d'un mode charge ou charge régénérative, les tensions mesurées $V_{m\_cell}$ sont surestimées par rapport à la valeur réelle de tension de la cellule considérée, l'importance d'une telle surestimation étant amenée à varier en fonction de la barre d'interconnexion considérée. Il en résulte que les procédés sécuritaires, limitant la puissance de charge $P_c$ ou de charge régénérative $P_{c\_regen}$ sont déclenchés plus tôt que nécessaire, alors que la tension réelle de la cellule est comprise dans la plage de valeur acceptable, du fait de la tension additionnelle de la barre d'interconnexion 5 comprise dans cette mesure. Cela génère une augmentation du temps de charge nécessaire mais également une limitation injustifiée des performances du véhicule.

Dans le contexte de la présente invention, le procédé 100 permet de limiter de tels inconvénients en basant la détermination de la puissance de charge $P_c$ ou de la puissance de charge régénérative $P_{c\_regen}$ sur la base de la tension corrigée $V_{corr}$ estimée, plus représentative de la réalité, plutôt que sur la base de la tension mesurée $V_{m\_cell}$.

En ce sens, l'étape d'ajustement et/ou de détermination E08 d'au moins un paramètre relatif au dispositif de batterie 2 peut comprendre, dans un premier temps, une sous-étape de détermination E091 d'une valeur maximale de tension au sein du dispositif de batterie 2 par l'intermédiaire de l'unité de traitement 7. Une telle valeur maximale est déterminée parmi un ensemble formé par les valeurs de tensions mesurées $V_{m\_cell}$, pour les cellules 4b n'étant pas reliées à une barre d'interconnexion 5, et par les tensions corrigées $V_{corr}$ estimées telles que calculées précédemment, pour les cellules 4a reliées à une barre d'interconnexion 5.

Particulièrement, une telle sous-étape peut être définie selon :

$$(3)\ V_{max} = Max \left\{ V_{m\_cell} - R_{est} \times I_m \right\}_{i=1}^{nbr\_cell}$$

Où :

$V_{max}$ est la tension maximale déterminée à l'échelle du dispositif de batterie 2. $V_{m\_cell}$ est la tension mesurée pour chaque cellule, reliée ou non à une barre d'interconnexion 5. $R_{est}$ est la résistance estimée de la barre d'interconnexion 5 considérée précédemment calculée, une telle valeur étant nulle dans le cas des cellules 4b n'étant pas reliée à une barre d'interconnexion 5. $I_m$ est le courant circulant dans le dispositif de batterie 2, le produit de la résistance estimée et du courant définissant, comme décrit plus haut, une valeur estimée de la tension additionnelle propre à la barre d'interconnexion 5. $nbr\_cell$ est le nombre de cellules 4 comprises dans l'ensemble du dispositif de batterie 2.

Le procédé 100 peut ensuite comprendre une sous-étape de détermination E092, en fonction de la valeur maximale $V_{max}$ de tension définie, d'une puissance de charge $P_c$ en prévision de l'exécution d'un mode charge, ou, alternativement, pour un mode charge mis en œuvre pendant l'exécution du procédé selon l'invention. L'unité de traitement 7 compare la valeur maximale $V_{max}$ de tension définie à un seuil maximal $S_{c\_max}$ de tension de charge autorisé. Si la valeur maximale $V_{max}$ de tension déterminée est supérieure ou égale audit seuil, alors la puissance de charge $P_c$ allouée est limitée, notamment selon des procédés sécuritaires, aussi qualifié de « derating ».

Si la valeur maximale $V_{max}$ de tension calculée est inférieure audit seuil, l'unité de traitement 7 du système de gestion 6, ou, de manière alternative, tout autre module de traitement équipant le véhicule 1 et communiquant avec l'unité de traitement 7, peut définir une puissance de charge $P_c$ pouvant être allouée au dispositif de batterie 2 lorsque celui-ci est dans le mode charge. Autrement dit, l'unité de traitement 7 peut définir la puissance de charge adaptée $P_c$ lorsque la tension maximale $V_{max}$ est comprise dans une plage de valeurs de tension acceptées préalablement définie, inférieure au seuil maximal de tension de charge. Un principe similaire s'applique *mutatis mutandis* à la puissance de charge régénérative pour le mode de charge régénérative.

A titre d'exemple non limitatif, la puissance de charge $P_c$ peut être définie en fonction de la tension maximale calculée $V_{max}$ et de la température mesurée du module $T_{mod}$ en se basant sur une cartographie 2D enregistrée sur l'unité de traitement et propre au mode d'utilisation du dispositif de batterie 2 considéré. Selon un exemple particulier, une température minimale et une température maximale sont extraites parmi les températures $T_{mod}$ des différents modules mesurées au préalable, puis sont utilisées afin de définir deux puissances de charge $P_c$ en de la cartographie 2D précitée. La puissance la plus basse parmi ces deux puissances peut ensuite être appliquée en tant que puissance de charge $P_c$.

Selon un mode de réalisation particulier, illustré à la figure 3, le procédé peut également être configuré de manière à limiter, voire prévenir, des situations générant des oscillations de la tension et de la puissance lorsque le mode charge est mis en œuvre. En effet, il est connu que, moins une cellule est chargée, plus la tension est basse et plus la puissance de charge allouée est importante. Quand les cellules 4 commencent à se charger, la tension augmente et la puissance allouée à la charge diminue. Par voie de conséquence, une telle baisse de puissance de charge entraîne une baisse de la tension mesurée, incluant la tension additionnelle de la barre d'interconnexion 5 au niveau des cellules 4a reliées à une telle barre. La puissance de charge est alors augmentée, ce qui résulte en une nouvelle augmentation de la tension. Un tel enchaînement se répète et on observe alors un phénomène d'oscillation de la tension pouvant présenter des valeurs non négligeables de plusieurs dizaines de kilowatts.

Afin de résoudre les inconvénients susmentionnés, lorsqu'un mode de charge est détecté à l'étape E07, c'est-à-dire qu'un tel mode est en cours d'exécution, le procédé et le système selon l'invention peuvent avantageusement être configurés afin de limiter, la possibilité d'augmentation de la puissance de charge lorsque celle-ci a préalablement été réduite. En ce sens, le procédé peut comprendre, pour un dispositif en état de charge, une étape de régulation E10 de la puissance de charge comportant :

- une sous-étape de calcul E101 d'une variation $\Delta P_{c1}$ de la puissance de charge observée $P_{c\_n-1}$, $P_{c\_n}$, entre un instant $t_{n-1}$, passé, et un instant présent $t_n$;
- une sous-étape d'estimation E102 d'une puissance de charge $P_{c\_n+1}$ à mettre en œuvre à un instant $t_{n+1}$ à venir, et une sous-étape de détection E103 d'une augmentation à venir de la puissance de charge relativement à la variation de puissance $\Delta P_{c1}$ précédemment calculée et à la puissance de charge $P_{c\_n}$ observée à l'instant $t_n$. Une telle estimation peut, à titre d'exemple, être réalisée sur la base d'une cartographie 2D comme exposé plus haut ;
- une sous-étape de limitation E104 de la puissance de charge $P_{c\_n+1}$ à venir de sorte que, à l'instant $t_{n+1}$ la puissance de charge est limitée de manière à être inférieure ou égale à la puissance de charge $P_{c\_n}$ mise en œuvre à l'instant $t_n$.

Le procédé selon l'invention est, en outre, particulièrement configuré de manière à ce que la limitation de la puissance de charge peut être levée lorsqu'il est détecté E105 une variation $\Delta T_m$ de température d'au moins un module $T_{mod}$ du dispositif de batterie 2 supérieure à un seuil $T_s$ entre les instants $t_{n-1}$ et $t_n$. En effet, il est également connu que l'augmentation de la puissance de charge peut résulter d'un échauffement du dispositif de batterie 2 classiquement observé du fait de la circulation du courant dans les cellules 4. Le procédé comprend ainsi une sous-étape, non représentée, de calcul d'une variation $\Delta T_m$ de température d'au moins un module $T_{mod}$ entre les instants $t_{n-1}$ et $t_n$ propre aux différents modules, un tel calcul étant réalisé par l'unité de traitement 7 sur la base des mesures effectuées par les éléments esclaves 8 du dispositif de batterie 2. Le procédé comprend ensuite une sous-étape de comparaison de ces différentes valeurs avec le seuil $T_s$. A titre d'exemple non limitatif, un tel seuil peut être compris entre 1 et 5°C. Lorsque la variation $\Delta T_m$ est inférieure au seuil $T_s$, l'augmentation de puissance estimée à venir est due à la variation de tension et non à la température. La puissance de charge $P_c$ est limitée de manière à être inférieure ou égale à celle mise en œuvre à l'instant $t_n$. A l'inverse, si la variation de température $\Delta T_m$ est supérieure audit seuil, l'augmentation de puissance estimée à venir est au moins en partie due à variation de la température du dispositif de batterie 2. La puissance de charge $P_c$ pourra donc augmenter. D'éventuelles oscillations peuvent alors être générées mais celles-ci présentent des valeurs moindres relativement à celles observées du fait d'une variation de tension.

Les figures 2 et 3 illustrent également la détermination de paramètres relatifs au mode de décharge du dispositif de batterie 2, par exemple en cas de roulage du véhicule 1. Similairement à ce qui a été exposé en référence à l'état de charge, les véhicules mettent classiquement en œuvre, lors de la décharge du dispositif de batterie 2, des procédés sécuritaires, ou « derating », afin de maintenir la température et/ou la tension des différentes cellules 4 dans des plages de valeurs adaptées, en particulier ici afin de prévenir des situations de sous-tension. De tels procédés sécuritaires permettent d'adapter une puissance de décharge, à distinguer de la puissance de charge $P_c$ précédemment exposée, en fonction de la tension des cellules 4 afin de limiter, c'est-à-dire réduire, la puissance de décharge dès lors que la tension d'une cellule est inférieure ou égale à seuil minimal de tension prédéterminé, propre au mode de décharge du dispositif de batterie 2. Comme exposé précédemment, il en résulte que, lorsque les mesures de tension des cellules 4a reliées à une barre d'interconnexion 5 sont erronées du fait de la tension de la barre d'interconnexion 5, ces procédés sécuritaires sont déclenchés plus tôt que nécessaire alors même que la tension réelle de la cellule est comprise dans la plage de valeur acceptable.

Le procédé 100 selon l'invention permet de limiter de tels inconvénients en déterminant la puissance de décharge $P_{de}$ sur la base de la tension corrigée estimée plutôt que sur la base de la tension mesurée $V_{m\_cell}$, notamment dans le cadre de tels procédés sécuritaires. L'étape d'ajustement et/ou de détermination E08 d'au moins un paramètre limitatif et/ou d'au moins un paramètre d'état peut ainsi comprendre une sous-étape de détermination E093 d'une valeur minimale de tension $V_{min}$ parmi les différentes valeurs de tension des cellules 4 du dispositif de batterie 2. La valeur minimale $V_{min}$ est définie parmi un ensemble de valeurs constitué des tensions mesurées $V_{m\_cell}$ des cellules 4a n'étant pas reliées à une barre d'interconnexion 5 et des tensions corrigées $V_{corr}$ estimées pour les cellules 4a reliées à une barre d'interconnexion 5.

Particulièrement, la valeur minimale de tension est définie selon :

$$(4)\ V_{min} = Min\left\{V_{m\_cell} - R_{est} \times I_m\right\}_{i=1}^{nbr\_cell}$$

Où :
$R_{est}$ est la résistance de la barre d'interconnexion 5 considérée précédemment estimée, une telle valeur $R_{est}$ étant nulle dans le cas des cellules 4b n'étant pas reliées à une barre d'interconnexion 5. $V_{cell}$ est la tension mesurée pour chaque cellule, reliée ou non à une barre d'interconnexion 5. $I_m$ est le courant circulant dans le dispositif de batterie 2. *nbr_cell* est le nombre de cellules 4 comprises dans l'ensemble du dispositif de batterie 2.

Le procédé peut ensuite comprendre une sous-étape de détermination E094, en fonction de la valeur minimale de tension $V_{min}$, d'une puissance $P_{de}$ de décharge adaptée pour la mise en œuvre d'un mode de décharge, en cours ou exécuté ultérieurement. L'unité de traitement 7 compare la valeur minimale de tension $V_{min}$ déterminée avec le seuil minimal de tension $S_{d\_min}$ de décharge autorisé.

Si la valeur minimale de tension $V_{min}$ déterminée est supérieure au seuil minimal de tension de décharge $S_{d\_min}$ autorisé, c'est à dire que la tension minimale au sein du dispositif de batterie 2 est comprise dans la plage de valeurs de tensions autorisée et que les procédés sécuritaires ne sont pas nécessaires, l'unité de traitement 7 du système de gestion 6, ou, de manière alternative, tout autre module de traitement équipant le véhicule 1, peut définir, de manière connue, une puissance de décharge $P_{de}$ pouvant être allouée au dispositif de batterie 2 sur la base d'une cartographie 2D dépendant de l'état de charge du dispositif de batterie 2, ou SOC de l'anglais « State of charge », et de la température. Particulièrement, le principe de définition d'une puissance en fonction d'une température minimale et d'une température maximale, exposé plus haut en référence à la puissance de charge $P_c$ s'applique *mutatis mutandis.*

Si la valeur minimale de tension $V_{min}$ est inférieure ou égale audit seuil, alors la puissance de décharge $S_{d\_min}$ allouée est limitée par rapport à la capacité maximale. Autrement dit, le déclenchement des procédés sécuritaires existants prend en considération la tension estimée $V_{corr}$ des cellules 4a de sorte que ceux-ci sont mis en œuvre à des valeurs de tensions plus représentatives de la tension réelle des cellules 4 du dispositif de batterie 2. La puissance de décharge $P_{de}$ est alors définie en fonction de la température et de la résistance des cellules 4, elle-même basée sur la tension mesuré $V_{m\_cell}$. De ce fait, le procédé selon l'invention permet une évaluation plus adaptée des résistances estimées prenant en compte la tension additionnelle des différentes barres d'interconnexion 5 et, par voie de conséquence, une meilleure évaluation des puissances de décharge $P_{de}$. Un tel principe sera d'autant plus vrai avec le vieillissement des cellules 4, leur résistance, et donc la résistance propre aux barres d'interconnexion 5, augmentant alors. En ce sens, l'étape d'ajustement et/ou de détermination E08 d'au moins un paramètre du fonctionnement du dispositif de batterie 2 peut comprendre une sous-étape d'estimation E095 d'une résistance $R_{d\_est}$ propre à chaque cellule 4a reliée à une barre d'interconnexion 5 à un instant $t_x$. Une telle résistance $R_{d\_est}$ est estimée par le calcul d'une résistance moyenne $R_m$ des cellules 4b du dispositif de batterie 2 n'étant pas reliées à une barre d'interconnexion 5, la résistance desdites cellules étant calculée en fonction des tensions mesurées $V_{m\_cell}$ et du courant $I_m$.

La valeur de cette moyenne de résistance $R_m$ est ensuite attribuée à chacun des cellules 4a reliées à une barre d'interconnexion 5. L'unité de traitement 7 peut ensuite exécuter une étape de détermination E096 d'une puissance de décharge $P_{de}$ du dispositif de batterie 2 en fonction des résistances des différentes cellules 4a, 4b, reliées ou non à une barre d'interconnexion 5, et de la température $T_{mod}$ mesurée pour chaque module 3. A titre d'exemple non limitatif, la puissance de décharge $P_{de}$ est définie, similairement à ce qui a été précédemment exposé, sur la base d'une cartographie 2D en fonction de la température des modules et/ou du dispositif de batterie, de l'état de charge du dispositif de batterie 2 et d'une valeur maximale de résistance, ladite valeur maximale étant déterminée parmi les résistances estimées dans le cas des cellules 4a reliées à une barre d'interconnexion 5 et des résistances calculées sur la base de la tension mesurée $V_{m\_cell}$ et du courant $I_m$ dans le cas des cellules 4b non reliée à une barre d'interconnexion 5.

Les valeurs de résistance $R_{d\_est}$ ainsi obtenues pour les cellules 4a reliées à des barres d'interconnexion 5 sont plus représentatives de la réalité et permettent de ne pas inclure la tension, et ici la résistance, additionnelle propre aux barres d'interconnexion 5. Une telle méthode est ici adaptée du fait que, à l'échelle du dispositif de batterie 2, le nombre de cellules 4a reliées à une barre d'interconnexion 5 est strictement inférieur au nombre de cellules 4b ne l'étant pas.

L'étape d'ajustement et/ou de détermination E08 d'au moins un paramètre du fonctionnement du dispositif de batterie 2 peut également comprendre, une sous-étape de détermination E098 d'une puissance de charge régénérative $P_{c\_regen}$. Similairement à ce qui a été exposé en référence aux modes de charge et de décharge, le véhicule peut également être configuré afin d'exécuter, lors des phases de charge régénérative, des procédés sécuritaires, ou « derating », afin de maintenir la température et/ou la tension des différentes cellules 4 dans des plages de valeurs adaptées.

En l'espèce, ces procédés sécuritaires permettent d'adapter la puissance charge régénérative $P_{c\_regen}$ afin de la limiter, c'est-à-dire réduire, dès lors que la tension d'une cellule est supérieure ou égale à seuil maximal de tension $S_{regen\_max}$ de charge régénérative autorisé. A noter qu'un tel seuil $S_{regen\_max}$ peut présenter une valeur identique ou distincte de celle du seuil maximal $S_{c\_max}$ de tension de charge.

Si la valeur maximale $V_{max}$ de tension calculée, notamment selon la formule (3) exposée plus haut en référence au mode charge, est inférieure audit seuil, c'est-à-dire que la valeur maximale $V_{max}$ de tension est comprise dans la plage de valeur normales, l'unité de traitement 7 du système de gestion 6, ou, de manière alternative, tout autre module de traitement peut définir une puissance de charge $P_{c\_regen}$ pouvant être allouée au dispositif de batterie 2 en fonction d'une cartographie 2D. La description précédente faite en référence au mode de décharge s'applique *mutatis mutandis*, la cartographie 2D considérée pouvant, à titre d'exemple non limitatif, être définie en fonction de la température des modules et/ou du dispositif de batterie, de l'état de charge et d'une valeur maximale de résistance tel qu'exposé ci-dessus.

Si la valeur maximale $V_{max}$ de tension déterminée est supérieure ou égale au seuil $S_{regen\_max}$, c'est-à-dire lorsque les procédés sécuritaires, ou de « derating », doivent être exécutés, alors la puissance de charge régénérative $P_{c\_regen}$ est limitée.

Comme exposé précédemment, la résistance des cellules 4 augmente avec leur vieillissement. Il en va de même pour les barres d'interconnexion 5. L'importance des surestimations ou sous-estimations des valeurs de tension ou de résistance tend donc à augmenter avec l'âge des cellules 4. Classiquement, le vieillissement d'une cellule 4 peut être estimé par la détermination d'un état résistif ER qui lui est propre. L'état résistif ER est obtenu par calcul de la résistance de la cellule sur la base de tension et du courant mesuré puis par comparaison de cette valeur à une valeur de résistance initiale, correspondant à la résistance de la cellule neuve enregistrée sur l'unité de mémoire 9 ou tout autre élément de mémoire du véhicule 1, afin de déterminer un pourcentage d'augmentation de la résistance interne de la cellule. Ce principe n'est pas adapté pour les cellules 4 reliées à une barre d'interconnexion 5 du fait des inconvénients précédemment mentionnés. Selon la présente invention, le calcul de l'état résistif ER est adapté afin de comparer la résistance estimée $R_{d\_est}$ des cellules 4a reliées à une barre d'interconnexion 5 avec la résistance initiale pour les cellules 4 reliées à une barre d'interconnexion.

L'état résistif ainsi estimé sera ainsi plus représentatif de la réalité du dispositif de batterie 2. L'état résistif ER pouvant également être utilisé pour le calcul ou l'estimation de différents paramètres de fonctionnement du dispositif de batterie 2, par exemple les puissances, le procédé selon l'invention permet ainsi une évaluation plus fiable de l'état du dispositif de batterie 2.

L'état de charge, ou « SOC » de l'anglais « State of Charge », du dispositif de batterie 2 est également un paramètre d'état du dispositif de batterie 2 utilisé dans de nombreux fonctionnements du véhicule 1, tels que la détermination de l'autonomie, de la puissance ou de la durée de la charge. Classiquement, l'état de charge SOC peut être estimé au moyen d'un filtre de Kalman basé sur la tension et le courant mesurés. Comme exposé plus haut, la tension mesurée au niveau des cellules 4a reliées à une barre d'interconnexion 5 étant erronée, la valeur d'état de charge SOC le sera également, ce qui engendre de nombreux effets non négligeables à l'échelle du véhicule 1.

Aussi, le procédé 100 selon l'invention peut avantageusement être adapté afin de déterminer un état de charge SOC plus représentatif de la réalité. L'étape d'ajustement et/ou de détermination E08 d'au moins un paramètre du dispositif de batterie 2 peut ainsi comprendre une sous-étape d'estimation E097 d'un état de charge des différentes cellules 4 du dispositif de batterie 2 dans laquelle :

- l'état de charge des cellules 4b n'étant pas reliées à au moins une barre d'interconnexion 5 est défini en fonction de la tension mesurée $V_{m\_cell}$ et du courant $I_m$ qui leur sont propres, notamment au moyen d'un filtre de Kalman ;
- l'état de charge des cellules 4a reliées à au moins une barre d'interconnexion 5 est défini en fonction du courant qui lui est propre selon :

$$(4)\ SOC_t = SOC_{t-1} + \frac{I_m \times \Delta t}{C}$$

Où : $SOC_t$ est l'état de charge d'une cellule reliée à une barre d'interconnexion 5 à l'instant t, $I_m$ est le courant circulant dans la cellule mesuré, C est la capacité de la cellule, et $\Delta t$ est le temps d'échantillonnage, par exemple en heures.

Le procédé selon l'invention peut ainsi être exécuté de manière à ce que, lors de l'étape d'ajustement et/ou de détermination E08 d'au moins un paramètre limitatif et/ou d'état du fonctionnement du dispositif de batterie 2, tout ou partie des différents paramètres précités peuvent être estimés, puis associés à au moins un état de fonctionnement du dispositif de batterie 2. Lesdits paramètres peuvent également être associés à d'autres fonctions du dispositif de batterie 2 et peuvent être transmis à différents systèmes équipant le véhicule 1, tels que des systèmes de localisation du véhicule 1 dans l'infrastructure routière ou des systèmes d'aide à la conduite. Selon un mode d'exécution préféré, les différents paramètres précités sont estimés indépendamment de l'utilisation faite du véhicule 1 au moment de l'exécution du procédé, autrement dit indépendamment du mode d'utilisation qui peut éventuellement être détecté au moment de l'exécution du procédé. Les paramètres ainsi estimés relatifs à un mode d'utilisation n'étant pas en cours d'exécution peuvent alors être enregistrés sur l'unité de mémoire 9 tandis que ceux relatifs à un mode en cours d'exécution peuvent être enregistrés et/ou appliqués directement à l'utilisation en cours.

Le procédé et le système selon l'invention permettent ainsi avantageusement une gestion du dispositif de batterie plus adaptée à son architecture. Il en résulte une optimisation de la durabilité mais également de l'exploitation des performances du dispositif de traitement. En outre, le fonctionnement de systèmes annexes équipant le véhicule et se basant sur des paramètres relatifs au dispositif de batterie s'en retrouve amélioré.

**Revendications**

1. Procédé de gestion (100) d'un dispositif de batterie (2) électrique comprenant une pluralité de modules (3) montés en série comportant chacun une pluralité de cellules (4) montées en série, chaque module étant directement électriquement relié à au moins un autre module de la pluralité de modules (3) de manière à former une paire de modules (3), cette liaison étant réalisée par l'intermédiaire d'une barre d'interconnexion (5) reliée au niveau d'une cellule (4a) de chacun des modules (3) de la paire, le procédé de gestion (100) comprenant :

   - une étape de mesure (E01) d'une tension ($V_{m\_cell}$) propre à chaque cellule (4, 4a, 4b), liée ou non à une barre d'interconnexion (5), par l'intermédiaire d'éléments esclaves (8) et une étape de mesure (E02) de la température ($T_{mod}$) de chaque module (3), chaque mesure de température ($T_{mod}$) étant associée à la ou aux barre(s) d'interconnexion (5) reliée(s) au module considéré, chaque élément esclave (8) comprenant une pluralité de voies (11) de mesures et étant relié aux deux modules (3) de la paire considérée;
   - une étape de mesure (E03) d'un courant ($I_m$) circulant dans le dispositif de batterie (2) ;
   - une étape de transmission (E04) des mesures à une unité de traitement (7) distante du dispositif de batterie (2) ;

   **caractérisé en ce que** le procédé comprend :

   - une étape d'estimation (E05) d'une valeur de compensation de tension ($V_{b\_est}$) propre à chaque cellule (4a) reliée à une barre d'interconnexion (5), la valeur de compensation ($V_{b\_est}$) correspondant à une tension estimée de la barre d'interconnexion (5) considérée pour chacune desdites cellules (4a), la valeur de compensation ($V_{b\_est}$) étant estimée en fonction de la température ($T_{mod}$) et du courant ($I_m$) du module (3) comprenant la cellule considérée ;
   - une étape d'estimation (E06) d'une valeur de tension corrigée ($V_{corr}$) propre à chacune des cellules (4a) reliées à une barre d'interconnexion (5) par compensation de la valeur de tension ($V_{m\_cell}$) mesurée avec la valeur de compensation estimée ($V_{b\_est}$) ;
   - une étape d'ajustement et/ou de détermination (E08) d'au moins un paramètre limitatif et/ou d'état du fonctionnement du dispositif de batterie (2) en fonction de la tension corrigée estimée ($V_{corr}$) et/ou en fonction de la tension mesurée ($V_{m\_cell}$).

2. Procédé de gestion (100) selon la revendication précédente, dans lequel la valeur de compensation dépend d'une résistance estimée ($R_{est}$) de la barre d'interconnexion (5) reliée à la cellule (4a) considérée, la résistance estimée étant définie selon:

$$R_{est} = R_{ref} \times \left( 1 + \alpha_1 \times \left( T_{mod} - T_{ref} \right) \right)$$
$$+ R_{cont} \times \left( 1 + \alpha_2 \times \left( T_{mod} - T_{ref} \right) \right)$$

   Où :

   $T_{ref}$ est une valeur de température fixe, de référence ;
   $R_{ref}$ est une valeur fixe d'estimation de la résistance de la barre d'interconnexion (5) basée sur ses dimensions et sa composition à la température de référence $T_{ref}$ ;
   $T_{mod}$ est la température du module auquel la barre d'interconnexion (5) considérée est liée ;
   $R_{cont}$ est une valeur fixe estimée de la résistance de contact existant entre le module considéré et la barre d'interconnexion (5) qui lui est reliée ;
   $\alpha_1$ est une valeur fixe représentative de l'augmentation de la résistance de référence en fonction de la température ;
   $\alpha_2$ est une valeur fixe représentative de l'augmentation de la résistance de contact en fonction de la température.

3. Procédé de gestion (100) selon la revendication précédente, dans lequel l'étape de détermination (E08) d'au moins un paramètre limitatif et/ou d'au moins un paramètre d'état comprend :

   - une sous-étape de détermination (E091) d'une valeur maximale ($V_{max}$) de tension propre à une cellule (4) parmi un ensemble formé des valeurs de tension mesurées ($V_{m\_cell}$), pour les cellules (4b) n'étant pas reliées à une barre d'interconnexion (5), et des tensions corrigées ($V_{corr}$) estimées, pour les cellules (4a) reliées à au moins une barre d'interconnexion (5) ; et

- une sous-étape de détermination (E092), en fonction de la valeur maximale de tension ($V_{max}$), d'une puissance de charge ($P_c$) pouvant être allouée au dispositif de batterie (2) lorsque celui-ci est dans un mode de charge, la puissance de charge ($P_c$) étant limitée lorsque la valeur maximale de tension ($V_{max}$) est supérieure ou égale à un seuil maximal de tension de charge ($S_{c\_max}$); et/ou

- une sous-étape de détermination (E098), en fonction de la valeur maximale de tension, d'une puissance de charge régénérative ($P_{c\_regen}$) pouvant être allouée au dispositif de batterie (2) lorsque celui-ci est dans un état de charge régénérative, la puissance de charge régénérative ($P_{c\_regen}$) étant limitée lorsque la valeur maximale de tension est supérieure ou égale à un seuil maximal de tension de charge régénérative ($S_{regen\_max}$).

4. Procédé de gestion (100) selon la revendication précédente, dans lequel la valeur maximale de tension est définie selon :

$$V_{max} = Max \left\{ V_{m\_cell} - R_{est} \times I_m \right\}_{i=1}^{nbr\_cell}$$

Où :

$R_{est}$ est la résistance estimée de la barre d'interconnexion considérée ;
$V_{m\_cell}$ est la tension mesurée pour chaque cellule, reliée ou non à une barre d'interconnexion (5) ;
$I$ est le courant circulant dans la batterie (2) ;
$nbr\_cell$ est le nombre de cellules (4) comprises dans l'ensemble du dispositif de batterie (2).

5. Procédé de gestion (100) selon la revendication 3 ou 4, comprenant, une étape de détermination (E07) d'un mode d'utilisation du dispositif de batterie (2) électrique parmi un mode de charge, de décharge ou de charge régénérative, le procédé exécutant, lorsqu'un un mode de charge, est détecté, une étape de régulation (E10) de la puissance de charge comportant :

- une sous-étape de calcul (E101) d'une variation de la puissance de charge ($\Delta P_{c1}$) entre les puissances de charge ($P_{c\_n}$ , $P_{c\_n-1}$) observées respectivement entre deux instants $t_{n-1}$ et $t_n$;
- une sous-étape d'estimation (E102) d'une puissance de charge ($P_{c\_n+1}$) à mettre en œuvre à un instant $t_{n+1}$ à venir, et une sous-étape de détection (E103) d'une augmentation à venir de la puissance de charge relativement à la variation de puissance précédemment calculée ($\Delta P_{c1}$) et à la puissance de charge ($P_{c\_n}$) observée à l'instant $t_n$;
- une étape de limitation (E104) de la puissance de charge ($P_{c\_n+1}$) à venir de sorte que, à l'instant $t_{n+1}$ la puissance de charge ($P_{c\_n+1}$) est limitée de manière à être inférieure ou égale à la puissance de charge ($P_{c\_n}$) mise en œuvre à l'instant $t_n$, la limitation de la puissance de charge étant levée lorsqu'il est détecté (E105) une variation ($\Delta T_m$) de température d'au moins un module ($T_{mod}$) supérieure à un seuil ($T_s$) de température prédéterminé entre les instants $t_{n-1}$ et $t_n$.

6. Procédé de gestion (100) selon l'une des revendications 2 à 5, dans lequel l'étape de détermination (E08) d'au moins un paramètre limitatif et/ou d'au moins un paramètre d'état comprend :

- une sous-étape de détermination (E093) d'une valeur minimale ($V_{min}$) de tension d'une cellule parmi un ensemble comprenant les valeurs de tension mesurées, pour les cellules (4) n'étant pas reliées à une barre d'interconnexion (5), et parmi les tensions corrigées ($V_{corr}$) estimées, pour les cellules (4) reliées à une barre d'interconnexion (5) ;
- une sous-étape de détermination (E094) d'une puissance de décharge ($P_{de}$) du dispositif de batterie (2) en fonction de la valeur minimale de tension ($V_{min}$), la puissance de décharge ($P_{de}$) étant limitée lorsque la valeur minimale de tension ($V_{min}$) est inférieure ou égale à un seuil minimal de tension de décharge ($S_{d\_min}$).

7. Procédé de gestion (100) selon la revendication précédente, dans lequel la valeur minimale de tension est définie selon :

$$V_{min} = Min \left\{ V_{m\_cell} - R_{est} \times I_m \right\}_{i=1}^{nbr\_cell}$$

Où :

$R_{est}$ est la résistance estimée de la barre d'interconnexion considérée ;
$V_{m\_cell}$ est la tension mesurée pour chaque cellule, reliée ou non à une barre d'interconnexion (5) ;
1 est le courant circulant dans le dispositif de batterie (2) ;
nbr_cell est le nombre de cellules (4) comprises dans l'ensemble du dispositif de batterie (2).

8. Procédé de gestion (100) selon l'une des revendications 6 ou 7, dans lequel l'étape de détermination (E08) d'au moins un paramètre limitatif et/ou d'au moins un paramètre comprend :

- une sous-étape d'estimation (E095) d'une résistance de chaque cellule reliée à une barre d'interconnexion (5) à un instant $t_x$, comprenant le calcul d'une résistance moyenne des cellules (4) du dispositif de batterie (2) n'étant pas reliées à une barre d'interconnexion (5) en fonction des tensions mesurées pour ces cellules (4) et l'attribution de la valeur d'une telle moyenne à chaque cellule reliée à une barre d'interconnexion (5) ;
- une sous-étape de détermination (E096) d'une puissance de décharge ($P_{de}$) pouvant être allouée au dispositif de batterie (2) lorsque la valeur minimale de tension ($V_{min}$) est supérieure au seuil minimal de tension de décharge ($S_{d\_min}$), la puissance de décharge ($P_{de}$) étant déterminée en fonction des résistances des différentes cellules (4) et de la température mesuré pour chaque module .

9. Procédé de gestion (100) selon l'une des revendications précédentes, dans lequel l'étape de détermination (E08) d'au moins un paramètre limitatif et/ou d'au moins un paramètre comprend une sous-étape d'estimation (E097) d'un état de charge (SOC) des différentes cellules (4) du dispositif de batterie (2) :

- l'état de charge des cellules (4b) n'étant pas reliées à une barre d'interconnexion (5) étant défini en fonction de la tension mesurée et du courant qui leur sont propres ;
- l'état de charge des cellules (4a) reliées à une barre d'interconnexion (5) étant défini en fonction du courant qui lui est propre selon :

$$SOC_t = SOC_{t-1} + \frac{I_m \times \Delta t}{C}$$

Où :

$SOC_t$ est l'état de charge d'une cellule reliée à une barre d'interconnexion (5) à l'instant t ;
$I_m$ est le courant circulant dans le dispositif de batterie ;
C est la capacité d'une cellule reliée à une barre d'interconnexion (5) ;
$\Delta t$ est le temps d'échantillonnage.

10. Système de gestion (6) d'un dispositif de batterie (2) électrique comprenant une pluralité de modules (3) comportant chacun une pluralité de cellules (4), chaque module étant directement électriquement relié à au moins un autre module de la pluralité de modules de manière à former une paire de modules, cette liaison étant réalisée par l'intermédiaire d'une barre d'interconnexion (5) liée au niveau d'une cellule de chacun des modules de la paire, les différents modules (3) étant électriquement relié les uns aux autres, le système comprenant des éléments matériels et/ou logiciels mettant en œuvre le procédé de gestion (100) selon l'une des revendications précédentes, les éléments matériels comportant au moins un élément esclave apte à réaliser des mesures de températures et de tension (8) relié à chacun des modules de la paire, une unité de traitement (7) apte à recevoir des mesures de l'au moins un élément esclave (8), une unité de mémoire (9) et au moins un capteur de courant (10).

11. Véhicule (1) automobile à motorisation hybride ou électrique comprenant au moins un dispositif de batterie (2) électrique comprenant une pluralité de modules (3) comportant chacun une pluralité de cellules (4), chaque module étant électriquement relié à chacun des autres modules (3) de la pluralité de modules (3) par l'intermédiaire d'une barre d'interconnexion (5) au niveau d'au moins une cellule, le véhicule (1) étant, en outre, équipé d'un système de gestion (6) selon la revendication précédente.

**Patentansprüche**

1. Verwaltungsverfahren (100) für eine elektrische Batterievorrichtung (2), die eine Vielzahl von in Reihe geschalteten Modulen (3) umfasst, die jeweils eine Vielzahl von in Reihe geschalteten Zellen (4) beinhalten, wobei jedes Modul mit mindestens einem anderen Modul der Vielzahl von Modulen (3) direkt elektrisch verbunden ist, so dass ein Paar aus Modulen (3) gebildet wird, wobei diese Verbindung über eine Stromschiene (5) ausgeführt wird, die im Bereich einer Zelle (4a) jedes der Module (3) des Paars verbunden wird, wobei das Verwaltungsverfahren (100) umfasst:

   - einen Schritt des Messens (E01) einer spezifischen Spannung ($V_{m\_cell}$) jeder Zelle (4, 4a, 4b), ob mit einer Stromschiene (5) verbunden oder nicht, über Slave-Elemente (8) und einen Schritt des Messens (E02) der Temperatur ($T_{mod}$) jedes Moduls (3), wobei jede Temperaturmessung ($T_{mod}$) der oder den mit dem betrachteten Modul verbundenen Stromschiene(n) (5) zugeordnet wird, wobei jedes Slave-Element (8) eine Vielzahl von Messkanälen (11) umfasst und mit den beiden Modulen (3) des betrachteten Paars verbunden ist;
   - einen Schritt des Messens (E03) eines Stroms ($I_m$), der in der Batterievorrichtung (2) fließt;
   - einen Schritt des Übertragens (E04) der Messungen an eine Verarbeitungseinheit (7), die von der Batterievorrichtung (2) entfernt ist;

   **dadurch gekennzeichnet, dass** das Verfahren umfasst:

   - einen Schritt des Schätzens (E05) eines spezifischen Spannungskompensationswerts ($V_{b\_est}$) jeder mit einer Stromschiene (5) verbundenen Zelle (4a), wobei der Kompensationswert ($V_{b\_est}$) einer geschätzten Spannung der betrachteten Stromschiene (5) für jede der Zellen (4a) entspricht, wobei der Kompensationswert ($V_{b\_est}$) in Abhängigkeit von der Temperatur ($T_{mod}$) und von dem Strom ($I_m$) des Moduls (3), das die betrachtete Zelle umfasst, geschätzt wird;
   - einen Schritt des Schätzens (E06) eines spezifischen korrigierten Spannungswerts ($V_{corr}$) jeder der mit einer Stromschiene (5) verbundenen Zellen (4a) durch Kompensation des gemessenen Spannungswerts ($V_{m\_cell}$) mit dem geschätzten Kompensationswert ($V_{b\_est}$);
   - einen Schritt des Anpassens und/oder Ermittelns (E08) mindestens eines begrenzenden und/oder Zustandsparameters des Betriebs der Batterievorrichtung (2) in Abhängigkeit von der geschätzten korrigierten Spannung ($V_{corr}$) und/oder in Abhängigkeit von der gemessenen Spannung ($V_{m\_cell}$).

2. Verwaltungsverfahren (100) nach dem vorhergehenden Anspruch, wobei der Kompensationswert von einem geschätzten Widerstand ($R_{est}$) der mit der betrachteten Zelle (4a) verbundenen Stromschiene (5) abhängt, wobei der geschätzte Widerstand definiert ist gemäß:

$$R_{est} = R_{ref} \times \left(1 + \alpha_1 \times \left(T_{mod} - T_{ref}\right)\right) + R_{cont} \times \left(1 + \alpha_2 \times \left(T_{mod} - T_{ref}\right)\right)$$

   Worin:

   $T_{ref}$ ein fester Referenztemperaturwert ist;
   $R_{ref}$ ein fester Schätzwert des Widerstands der Stromschiene (5) ist, der auf ihren Abmessungen und ihrer Zusammensetzung bei der Referenztemperatur $T_{ref}$ beruht;
   $T_{mod}$ die Temperatur des Moduls ist, mit dem die betrachtete Stromschiene (5) verbunden ist;
   $R_{cont}$ ein geschätzter fester Wert des Kontaktwiderstands ist, der zwischen dem betrachteten Modul und der Stromschiene (5), die mit ihm verbunden ist, vorliegt;
   $\alpha_1$ ein fester Wert ist, der für die Erhöhung des Referenzwiderstands in Abhängigkeit von der Temperatur repräsentativ ist;
   $\alpha_2$ ein fester Wert ist, der für die Erhöhung des Kontaktwiderstands in Abhängigkeit von der Temperatur repräsentativ ist.

3. Verwaltungsverfahren (100) nach dem vorhergehenden Anspruch, wobei der Schritt des Ermittelns (E08) mindestens eines begrenzenden Parameters und/oder mindestens eines Zustandsparameters umfasst:

   - einen Teilschritt des Ermittelns (E091) eines spezifischen maximalen Spannungswerts ($V_{max}$) einer Zelle (4) aus einer Gruppe, die aus den gemessenen Spannungswerten ($V_{m\_cell}$) für die Zellen (4b), die nicht mit einer Stromschiene (5) verbunden sind, und aus den geschätzten korrigierten Spannungen ($V_{corr}$) für die Zellen (4a), die mit mindestens einer Stromschiene (5) verbunden sind, gebildet wird; und

- einen Teilschritt des Ermittelns (E092), in Abhängigkeit von dem maximalen Spannungswert ($V_{max}$), einer Ladeleistung ($P_c$), die der Batterievorrichtung (2) zugewiesen werden kann, wenn diese in einem Lademodus ist, wobei die Ladeleistung ($P_c$) begrenzt wird, wenn der maximale Spannungswert ($V_{max}$) größer als oder gleich einem maximalen Schwellenwert einer Ladespannung ($S_{c\_max}$) ist; und/oder

- einen Teilschritt des Ermittelns (E098), in Abhängigkeit von dem maximalen Spannungswert, einer Leistung für regeneratives Laden ($P_{c\_regen}$), die der Batterievorrichtung (2) zugewiesen werden kann, wenn diese in einem Zustand des regenerativen Ladens ist, wobei die Leistung für regeneratives Laden ($P_{c\_regen}$) begrenzt wird, wenn der maximale Spannungswert größer als oder gleich einem maximalen Schwellenwert einer Spannung für regeneratives Laden ($S_{regen\_max}$) ist.

4. Verwaltungsverfahren (100) nach dem vorhergehenden Anspruch, wobei der maximale Spannungswert definiert ist gemäß:

$$V_{max} = Max\left\{V_{m\_cell} - R_{est} \times I_m\right\}_{i=1}^{nbr\_cell}$$

Worin:

$R_{est}$ der geschätzte Widerstand der betrachteten Stromschiene ist;
$V_{m\_cell}$ die gemessene Spannung für jede Zelle ist, ob mit einer Stromschiene (5) verbunden oder nicht;
I der in der Batterie (2) fließende Strom ist;
$nbr\_cell$ die Anzahl von Zellen (4) ist, die in der gesamten Batterievorrichtung (2) enthalten sind.

5. Verwaltungsverfahren (100) nach Anspruch 3 oder 4, umfassend einen Schritt des Ermittelns (E07) eines Verwendungsmodus der elektrischen Batterievorrichtung (2) unter einem Lade-, Entlade oder regenerativen Lademodus, wobei das Verfahren, wenn ein Lademodus detektiert wird, einen Schritt des Regulierens (E10) der Ladeleistung ausführt, der beinhaltet:

- einen Teilschritt des Berechnens (E101) einer Änderung der Ladeleistung ($\Delta P_{c1}$) zwischen den Ladeleistungen ($P_{c\_n}$, $P_{c\_n-1}$), die zwischen zwei Zeitpunkten $t_{n-1}$ und $t_n$ beobachtet werden;
- einen Teilschritt des Schätzens (E102) einer Ladeleistung ($P_{c\_n+1}$), die zu einem zukünftigen Zeitpunkt $t_{n+1}$ zu implementieren ist, und einen Teilschritt des Detektierens (E103) einer zukünftigen Erhöhung der Ladeleistung bezüglich der zuvor berechneten Leistungsänderung ($\Delta P_{c1}$) und der Ladeleistung ($P_{c\_n}$), die zu dem Zeitpunkt $t_n$ beobachtet wird;
- einen Schritt des Begrenzens (E104) der zukünftigen Ladeleistung ($P_{c\_n+1}$), so dass zu dem Zeitpunkt $t_{n+1}$ die Ladeleistung ($P_{c\_n+1}$) so begrenzt wird, dass sie kleiner als oder gleich der Ladeleistung ($P_{c\_n}$) ist, die zu dem Zeitpunkt $t_n$ implementiert wird, wobei die Begrenzung der Ladeleistung aufgehoben wird, wenn eine Änderung ($\Delta T_m$) der Temperatur mindestens eines Moduls ($T_{mod}$), die größer als ein vorbestimmter Temperaturschwellenwert ($T_s$) ist, zwischen den Zeitpunkten $t_{n-1}$ und $t_n$ detektiert wird (E105).

6. Verwaltungsverfahren (100) nach einem der Ansprüche 2 bis 5, wobei der Schritt des Ermittelns (E08) mindestens eines begrenzenden Parameters und/oder mindestens eines Zustandsparameters umfasst:

- einen Teilschritt des Ermittelns (E093) eines minimalen Spannungswerts ($V_{max}$) einer Zelle aus einer Gruppe, die die gemessenen Spannungswerte für die Zellen (4), die nicht mit einer Stromschiene (5) verbunden sind, umfasst, und unter den geschätzten korrigierten Spannungen ($V_{corr}$), für die Zellen (4), die mit mindestens einer Stromschiene (5) verbunden sind;
- einen Teilschritt des Ermittelns (E094) einer Entladeleistung ($P_{de}$) der Batterievorrichtung (2) in Abhängigkeit von dem minimalen Spannungswert ($V_{min}$), wobei die Ladeleistung ($P_{de}$) begrenzt wird, wenn der minimale Spannungswert ($V_{min}$) kleiner als oder gleich einem minimalen Schwellenwert einer Entladespannung ($S_{d\_min}$) ist.

7. Verwaltungsverfahren (100) nach dem vorhergehenden Anspruch, wobei der minimale Spannungswert definiert ist gemäß:

$$V_{min} = Min\left\{V_{m\_cell} - R_{est} \times I_m\right\}_{i=1}^{nbr\_cell}$$

Worin:

$R_{est}$ der geschätzte Widerstand der betrachteten Stromschiene ist;
$V_{m\_cell}$ die gemessene Spannung für jede Zelle ist, ob mit einer Stromschiene (5) verbunden oder nicht;
I der in der Batterievorrichtung (2) fließende Strom ist;
*nbr_cell* die Anzahl von Zellen (4) ist, die in der gesamten Batterievorrichtung (2) enthalten sind.

8. Verwaltungsverfahren (100) nach einem der Ansprüche 6 oder 7, wobei der Schritt des Ermittelns (E08) mindestens eines begrenzenden Parameters und/oder mindestens eines Parameters umfasst:

- einen Teilschritt des Schätzens (E095) eines Widerstands jeder mit einer Stromschiene (5) verbundenen Zelle zu einem Zeitpunkt $t_x$, umfassend das Berechnen eines mittleren Widerstands der Zellen (4) der Batterievorrichtung (2), die nicht mit einer Stromschiene (5) verbunden sind, in Abhängigkeit von den für diese Zellen (4) gemessenen Spannungen und das Zuweisens des Werts eines solchen Mittelwerts zu jeder Zelle, die mit einer Stromschiene (5) verbunden ist;
- einen Teilschritt des Ermittelns (E096) einer Entladeleistung ($P_{de}$), die der Batterievorrichtung (2) zugewiesen werden kann, wenn der minimale Spannungswert ($V_{min}$) größer als der minimale Schwellenwert der Entladespannung ($S_{d\_min}$) ist, wobei die Entladeleistung ($P_{de}$) in Abhängigkeit von den Widerständen der verschiedenen Zellen (4) und von der für jedes Modul gemessenen Temperatur ermittelt wird.

9. Verwaltungsverfahren (100) nach einem der vorhergehenden Ansprüche, wobei der Schritt des Ermittelns (E08) mindestens eines begrenzenden Parameters und/oder mindestens eines Parameters einen Teilschritt des Schätzens (E097) eines Ladezustands (SOC) der verschiedenen Zellen (4) der Batterievorrichtung (2) umfasst:

- wobei der Ladezustand der Zellen (4b), die nicht mit einer Stromschiene (5) verbunden sind, in Abhängigkeit von der gemessenen Spannung und von dem Strom, die für sie spezifisch sind, definiert wird;
- wobei der Ladezustand der Zellen (4a), die mit einer Stromschiene (5) verbunden sind, in Abhängigkeit von dem für sie spezifischen Strom definiert wird gemäß:

$$SOC_t = SOC_{t-1} + \frac{I_m \times \Delta t}{C}$$

Worin:

$SOC_t$ der Ladezustand einer mit einer Stromschiene (5) verbundenen Zelle zum Zeitpunkt t ist;
$I_m$ der in der Batterievorrichtung fließende Strom ist;
C die Kapazität einer mit einer Stromschiene (5) verbundenen Zelle ist;
$\Delta t$ die Abtastzeit ist.

10. Verwaltungssystem (6) für eine elektrische Batterievorrichtung (2), die eine Vielzahl von Modulen (3) umfasst, die jeweils eine Vielzahl von Zellen (4) beinhalten, wobei jedes Modul mit mindestens einem anderen Modul der Vielzahl von Modulen direkt elektrisch verbunden ist, so dass ein Paar aus Modulen gebildet wird, wobei diese Verbindung über eine Stromschiene (5) ausgeführt wird, die im Bereich einer Zelle jedes der Module des Paars verbunden ist, wobei die verschiedenen Module (3) miteinander elektrisch verbunden sind, wobei das System Hardware- und/oder Softwareelemente umfasst, die das Verwaltungsverfahren (100) nach einem der vorhergehenden Ansprüche implementieren, wobei die Hardwareelemente mindestens ein zum Ausführen von Temperatur- und Spannungsmessungen (8) geeignetes Slave-Element, das mit jedem der Module des Paars verbunden ist, eine zum Empfangen der Messungen des mindestens einen Slave-Elements (8) geeignete Verarbeitungseinheit (7), eine Speichereinheit (9) und mindestens einen Stromsensor (10) beinhalten.

11. Kraftfahrzeug (1) mit Hybrid- oder Elektroantrieb, das mindestens eine elektrische Batterievorrichtung (2) umfasst, die eine Vielzahl von Modulen (3) umfasst, die jeweils eine Vielzahl von Zellen (4) beinhalten, wobei jedes Modul mit jedem der anderen Module (3) der Vielzahl von Modulen (3) über eine Stromschiene (5) im Bereich mindestens einer Zelle elektrisch verbunden ist, wobei das Fahrzeug (1) ferner mit einem Verwaltungssystem (6) nach dem vorhergehenden Anspruch ausgestattet ist.

**Claims**

1. Method (100) for managing an electric battery device (2) comprising a plurality of modules (3) mounted in series, each comprising a plurality of cells (4) mounted in series, each module being directly electrically connected to at least one other module of the plurality of modules (3) so as to form a pair of modules (3), with this connection being made by means of a busbar (5) connected at a cell (4a) of each of the modules (3) of the pair, the management method (100) comprising:

   - a step (E01) of measuring a voltage ($V_{m\_cell}$) specific to each cell (4, 4a, 4b), whether or not it is connected to a busbar (5), by means of slave elements (8), and a step (E02) of measuring the temperature ($T_{mod}$) of each module (3), with each temperature measurement ($T_{mod}$) being associated with the one or more busbars (5) connected to the considered module, each slave element (8) comprising a plurality of measurement channels (11) and being connected to the two modules (3) of the considered pair;
   - a step (E03) of measuring a current ($I_m$) flowing through the battery device (2);
   - a step (E04) of transmitting the measurements to a processing unit (7) remote from the battery device (2); **characterized in that** the method comprises:
   - a step (E05) of estimating a voltage compensation value ($V_{b\_est}$) specific to each cell (4a) connected to a busbar (5), the compensation value ($V_{b\_est}$) corresponding to an estimated voltage of the considered busbar (5) for each of said cells (4a), with the compensation value ($V_{b\_est}$) being estimated as a function of the temperature ($T_{mod}$) and of the current ($I_m$) of the module (3) comprising the considered cell;
   - a step (E06) of estimating a corrected voltage value ($V_{corr}$) specific to each of the cells (4a) connected to a busbar (5) by compensating the measured voltage value ($V_{m\_cell}$) with the estimated compensation value ($V_{b\_est}$);
   - a step (E08) of adjusting and/or determining at least one limiting and/or state parameter of the operation of the battery device (2) as a function of the estimated corrected voltage ($V_{corr}$) and/or as a function of the measured voltage ($V_{m\_cell}$).

2. Management method (100) according to the preceding claim, wherein the compensation value depends on an estimated resistance ($R_{est}$) of the busbar (5) connected to the considered cell (4a), with the estimated resistance being defined as follows:

$$R_{est} = R_{ref} \times \left(1 + \alpha_1 \times \left(T_{mod} - T_{ref}\right)\right) + R_{cont} \times \left(1 + \alpha_2 \times \left(T_{mod} - T_{ref}\right)\right)$$

where:

   $T_{ref}$ is a fixed, reference temperature value;
   $R_{ref}$ is a fixed value for estimating the resistance of the busbar (5) based on its dimensions and its composition at the reference temperature $T_{ref}$ ;
   $T_{mod}$ is the temperature of the module to which the considered busbar (5) is connected;
   $R_{cont}$ is an estimated fixed value of the contact resistance that exists between the considered module and the busbar (5) connected thereto;
   $\alpha_1$ is a fixed value representing the increase in the reference resistance as a function of the temperature;
   $\alpha_2$ is a fixed value representing the increase in the contact resistance as a function of the temperature.

3. Management method (100) according to the preceding claim, wherein the step (E08) of determining at least one limiting parameter and/or at least one state parameter comprises:

   - a sub-step (E091) of determining a maximum voltage value ($V_{max}$) specific to a cell (4) from among a set formed by the measured voltage values ($V_{m\_cell}$), for the cells (4b) that are not connected to a busbar (5), and the estimated corrected voltages ($V_{corr}$), for the cells (4a) that are connected to at least one busbar (5); and
   - a sub-step (E092) of determining, as a function of the maximum voltage value ($V_{max}$), a charging power ($P_c$) that can be allocated to the battery device (2) when it is in a charging mode, with the charging power ($P_c$) being limited when the maximum voltage value ($V_{max}$) is greater than or equal to a maximum charging voltage threshold ($S_{c\_max}$); and/or

- a sub-step (E098) of determining, as a function of the maximum voltage value, a regenerative charging power ($P_{c\_regen}$) that can be allocated to the battery device (2) when it is in a regenerative charging state, with the regenerative charging power ($P_{c\_regen}$) being limited when the maximum voltage value is greater than or equal to a maximum regenerative charging voltage threshold ($S_{regen\_max}$).

4. Management method (100) according to the preceding claim, wherein the maximum voltage value is defined as follows:

$$V_{max} = Max \left\{ V_{m\_cell} - R_{est} \times I_m \right\}_{i=1}^{nbr\_cell}$$

where:

$R_{est}$ is the estimated resistance of the considered busbar;
$V_{m\_cell}$ is the voltage measured for each cell, whether or not it is connected to a busbar (5);
I is the current flowing through the battery (2);
$nbr\_cell$ is the number of cells (4) included in the entire battery device (2).

5. Management method (100) according to Claim 3 or 4, comprising a step (E07) of determining a usage mode of the electric battery device (2) from among a charging, discharging or regenerative charging mode, the method executing, when a charging mode is detected, a step (E10) of regulating the charging power comprising:

- a sub-step (E101) of computing a variation in the charging power ($\Delta P_{c1}$) between the charging powers ($P_{c\_n}$, $P_{c\_n-1}$) respectively observed between two instants $t_{n-1}$ and $t_n$;
- a sub-step (E102) of estimating a charging power ($P_{c\_n+1}$) to be implemented at a future instant $t_{n+1}$, and a sub-step (E103) of detecting a future increase in the charging power with respect to the previously computed power variation ($\Delta P_{c1}$) and to the charging power ($P_{c\_n}$) observed at the instant $t_n$;
- a step (E104) of limiting the future charging power ($P_{c\_n+1}$) such that, at the instant $t_{n+1}$, the charging power ($P_{c\_n+1}$) is limited so as to be less than or equal to the charging power ($P_{c\_n}$) implemented at the instant $t_n$, with the limitation of the charging power being lifted when a temperature variation ($\Delta T_m$) of at least one module ($T_{mod}$) is detected (E105) as being greater than a predetermined temperature threshold ($T_s$) between the instants $t_{n-1}$ and $t_n$.

6. Management method (100) according to any of Claims 2 to 5, wherein the step (E08) of determining at least one limiting parameter and/or at least one state parameter comprises:

- a sub-step (E093) of determining a minimum voltage value ($V_{min}$) of a cell from among a set comprising the measured voltage values, for the cells (4) that are not connected to a busbar (5), and from among the estimated corrected voltages ($V_{corr}$), for the cells (4) that are connected to a busbar (5);
- a sub-step (E094) of determining a discharging power ($P_{de}$) of the battery device (2) as a function of the minimum voltage value ($V_{min}$), with the discharging power ($P_{de}$) being limited when the minimum voltage value ($V_{min}$) is less than or equal to a minimum discharging voltage threshold ($S_{d\_min}$).

7. Management method (100) according to the preceding claim, wherein the minimum voltage value is defined as follows:

$$V_{min} = Min \left\{ V_{m\_cell} - R_{est} \times I_m \right\}_{i=1}^{nbr\_cell}$$

where:

$R_{est}$ is the estimated resistance of the considered busbar;
$V_{m\_cell}$ is the voltage measured for each cell, whether or not it is connected to a busbar (5);
I is the current flowing through the battery device (2);
$nbr\_cell$ is the number of cells (4) included in the entire battery device (2).

8. Management method (100) according to either of Claims 6 and 7, wherein the step (E08) of determining at least one limiting parameter and/or at least one parameter comprises:

- a sub-step (E095) of estimating a resistance of each cell connected to a busbar (5) at an instant $t_x$, comprising computing an average resistance of the cells (4) of the battery device (2) that are not connected to a busbar (5) as a function of the voltages measured for these cells (4) and assigning the value of such an average to each cell connected to a busbar (5);
- a sub-step (E096) of determining a discharging power ($P_{de}$) that can be allocated to the battery device (2) when the minimum voltage value ($V_{min}$) is greater than the minimum discharging voltage threshold ($S_{d\_min}$), with the discharging power ($P_{de}$) being determined as a function of the resistances of the various cells (4) and of the measured temperature for each module.

9. Management method (100) according to any of the preceding claims, wherein the step (E08) of determining at least one limiting parameter and/or at least one parameter comprises a sub-step (E097) of estimating a state of charge (SOC) of the various cells (4) of the battery device (2):

- with the state of charge of the cells (4b) that are not connected to a busbar (5) being defined as a function of the measured voltage and the current that are specific thereto;
- with the state of charge of the cells (4a) that are connected to a busbar (5) being defined as a function of the current specific thereto as follows:

$$SOC_t = SOC_{t-1} + \frac{I_m \times \Delta t}{C}$$

where:

$SOC_t$ is the state of charge of a cell connected to a busbar (5) at the instant t;
$I_m$ is the current flowing through the battery device;
$C$ is the capacity of a cell connected to a busbar (5);
$\Delta t$ is the sampling time.

10. System (6) for managing an electric battery device (2) comprising a plurality of modules (3) each comprising a plurality of cells (4), with each module being directly electrically connected to at least one other module of the plurality of modules so as to form a pair of modules, with this connection being made by means of a busbar (5) connected at a cell of each of the modules of the pair, with the various modules (3) being electrically connected to each other, the system comprising hardware and/or software elements implementing the management method (100) according to any of the preceding claims, the hardware elements comprising at least one slave element capable of taking temperature and voltage measurements (8) connected to each of the modules of the pair, a processing unit (7) capable of receiving measurements from the at least one slave element (8), a memory unit (9) and at least one current sensor (10).

11. Hybrid or electric motor vehicle (1) comprising at least one electric battery device (2) comprising a plurality of modules (3) each comprising a plurality of cells (4), with each module being electrically connected to each of the other modules (3) of the plurality of modules (3) by means of a busbar (5) in the vicinity of at least one cell, with the vehicle (1) further being equipped with a management system (6) according to the preceding claim.

Fig. 1

Fig. 2

Fig. 3

100

E01/E02

E03

E04

E05

E06

E07

E08

E091

E092;
E098

E093

E094

E095

E096

E097

E10

E101

E102

E103

E104

E105

**EP 4 453 588 B1**

## RÉFÉRENCES CITÉES DANS LA DESCRIPTION

**Documents brevets cités dans la description**

- CN 107482699
- FR 3002325
- US 9733311 B